# EUROPEAN PATENT SPECIFICATION

(11) **EP 2 546 975 B1**
(45) Date of publication and mention of the grant of the patent: **20.04.2016**
(21) Application number: 11761899.1
(22) Date of filing: 06.01.2011
(51) Int. Cl.: H01L 31/054, F24J 2/52, F24J 2/54, G05D 3/10

(54) **SUNLIGHT-TRACKING DEVICE**
SONNENLICHTVERFOLGUNGSVORRICHTUNG
DISPOSITIF DE POURSUITE DU SOLEIL

(30) Priority: 27.07.2010 CN 201010244994; 02.04.2010 CN 201010138078
(43) Date of publication of application: 16.01.2013
(73) Proprietor: Liu, Jianzhong, Jinan, Shandong 250002 (CN)
(72) Inventor: Liu, Jianzhong, Jinan, Shandong 250002 (CN)
(74) Representative: Isarpatent
(86) International application number: PCT/CN2011/000029
(87) International publication number: WO 2011/120324

(56) References cited:
- WO-A1-2008/092195
- WO-A1-2008/154945
- CN-A- 101 577 512
- CN-A- 101 599 723
- CN-A- 101 599 723
- CN-A- 101 877 560
- DE-A1- 10 144 601
- DE-A1-102008 023 549
- DE-U1-202005 004 236
- DE-U1-202008 013 209
- KR-A- 20100 023 937
- US-A- 4 205 657
- US-A- 4 343 294
- US-A- 4 469 938
- US-A- 4 890 599
- US-A1- 2003 048 551
- US-A1- 2007 277 868

## Description

### BACKGROUND OF THE INVENTION

### 1. Field of the Invention

The present invention relates to a solar energy utilizing device, and particularly to an sunlight tracking device having a function of tracking sunlight with two shafts.

### 2. Description of the Related Art

Since fossil energy is being exhausted and problems such as environmental pollution and greenhouse effect are generated during production and use of the fossil energy become more and more serious, countries have attached increasing importance to development and utilization of new energy source. The solar energy is new energy that is effective, clean, widely distributed, and can be nearly limitedly utilized, this attracts people to gradually and significantly increase investment in development of the solar energy. However, nowadays the rate of utilization is generally low and generation cost is generally expensive in application of the solar energy especially in a field of photovoltaic generation. This is particularly true in the following two aspects. Firstly, since existing photovoltaic cell for photovoltaic generation technique mainly employs semiconductor material such as monocrystalline silicon and polycrystalline silicon, the price of the photovoltaic cell is expensive. Secondly, currently monocrystalline silicon panel of high-quality has only a photovoltaic conversion efficiency of up to about 17% and only a maximal lift time of twenty to thirty years so that cost of solar generation is enlarged and difficulty in marketing of solar generation is increased. Therefore, how to improve generation efficiency per unit of the existing photovoltaic panel becomes one of main ways to decrease the cost of solar generation while people manage to decrease cost of the panel and develop and utilize new panel material of a higher photovoltaic conversion efficiency.

The solar panel is usually fixedly mounted in an existing solar photovoltaic generation system so that it is ensured the sunlight irradiates the panel at an optimum angle only at one time of a day in every year. Therefore, that utilization efficiency of the sunlight is relatively low. If the solar panel is always maintained at an optimum angle to the sunlight or a light condensation technique is employed, more electrical energy can be obtained with the solar panel of the same area. All of this requires a mature reliable sunlight tracking technique. According to research, an amount of electrical energy generalized by the solar panel by using the sunlight tracking technique can be increased by more than 30-50% compared with the fixedly mounted solar panel depending upon sunlight irradiation conditions in different regions. However, most of the existing sunlight tracking techniques result in a high cost even a cost exceeding 30% of total investment in a generation device due to reasons such as complex structure. Furthermore, the tracking itself necessitates electrical energy consumption. A generation system using the tracking technique occupies more land area than that using the fixed solar panel, needs additional technical staff for maintenance of equipment, and has more operation risk than that using the fixed solar panel. In addition, in order to decrease tracking cost, currently, tracking devices made by manufacturers become increasingly bulky. This in turn results in a series of problems such as greater wind resistance, increased difficulty in installation and maintenance, and improved requirements for road and foundation. As a result, attraction of effect generated by the tracking technique is greatly decreased and commercialization of the sunlight tracking technique is hindered.

### SUMMARY OF THE INVENTION

An object of the present invention is to provide an sunlight tracking device having a capability of tracking sunlight with two shafts while the device has the advantages that the device has a firm structure, low cost and power consumption, reliable operation and convenient routine maintenance of the device itself.

This is achieved by a sun tracking device with the features of the independent claim.

The present invention has the following advantageous effects.
(1) The automatic sunlight tracking device according to the present invention has a simplified, reasonable and firm structure, and good mechanical performance. The device can be configured by multiple flexible combinations. Therefore, the device can be easily produced on mass production basis.
(2) A driving power required by the device is considerably decreased due to reasonable and simplified structure of the invention. Operation energy consumption of the device itself is greatly reduced by means of an operation timing control program and self-locking of the worm wheel and worm.
(3) The control program of the device is simplified by cooperation of the pitching angle tracking member and the swing angle tracking member so that accurate tracking can be achieved by an open-loop control system. The cost of the control system is reduced while probability of failure of the device is decreased, and installation and everyday maintenance of the device is facilitated.
(4) The device is widely applicable. Tracking of sunlight with either large or small panels can produce considerable economic benefit.
(5) The device solves the problem that the efficiency of the solar energy device varies as a point where the direct sunlight occurs moves between tropic of Capricorn and the tropic of Cancer. Therefore, the device can be widely used.

### BRIEF DESCRIPTION OF THE DRAWINGS

FIG. 1 is a structural view of an automatic sunlight tracking device according to a first exemplary embodiment which does not form part of this invention;
FIG. 2 is a schematic view of a part of components of the first embodiment;
FIG. 3 is a schematic view of various forms of a three-dimensional joint;
FIG. 4 is a schematic view showing installation of solar panels;
FIG. 5 is a structural view of an sunlight tracking device according to an embodiment of the invention;
FIG. 6 is a structural view of an automatic sunlight tracking device according to a second exemplary embodiment which does not form part of this invention;
FIG. 7 is a structural view of a pulley;
FIG. 8 is a structural view of an automatic sunlight tracking device according to a third exemplary embodiment which does not form part of this invention;
FIG. 9 is a structural view of an automatic sunlight tracking device according to a fourth exemplary embodiment which does not form part of this invention;
FIG. 10 is a structural view of an automatic sunlight tracking device according to a fifth exemplary embodiment which does not form part of this invention; and
FIG. 11 is a structural view of an automatic sunlight tracking device according to a sixth exemplary embodiment which does not form part of this invention.

List of reference numbers
- 1: Solar panel holder
- 11: Solar panel
- 2: Mounting
- 3: Three-dimensional joint
- 31: Pitching angle rotation supporting shaft
- 32: Left-right swing angle rotation supporting shaft
- 41: Third transmission rope
- 42: Fourth transmission rope
- 43: Rigid arc body
- 44: Positioning hole
- 45: Positioning pin
- 46: linearly-pushing rod
- 51: Rigid support
- 51': Rigid support
- 61: First gear
- 62: Second gear
- 7: Rigid semi-circular arc body
- 71: First transmission rope
- 72: Second transmission rope
- 81: First drive device
- 82: Second drive device
- 9: Pulley
- 91: Third helical guide groove
- 92: Fourth helical guide groove

### DETAILED DESCRIPTION OF THE EMBODIMENTS

The automatic sunlight tracking device comprises a solar panel holder 1, a mounting 2, a pitching angle tracking member, and a left-right swing angle tracking member.

### Embodiment 1

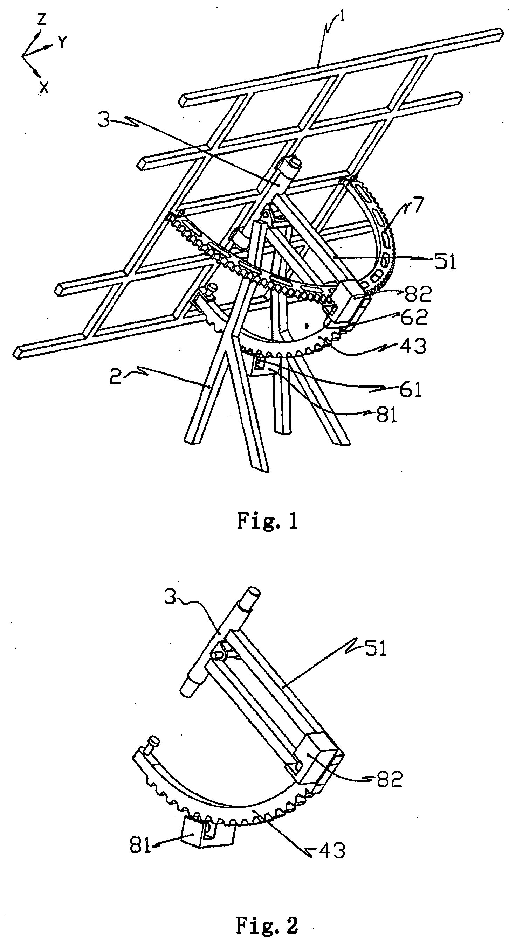

As illustrated in FIGS. 1-4, for purpose of clarity description, firstly, a Y direction is defined as a direction which is parallel to a plane in which the solar panel holder 1 is located and which is directed along a movement locus of the sun during one day, a Z direction is defined as a direction which is parallel to the plane in which the solar panel holder 1 is located and which is directed along a movement locus of the sun during one year, and then an X direction is defined as a direction which is perpendicular to a YZ plane and directed towards a back of the solar panel holder 1.

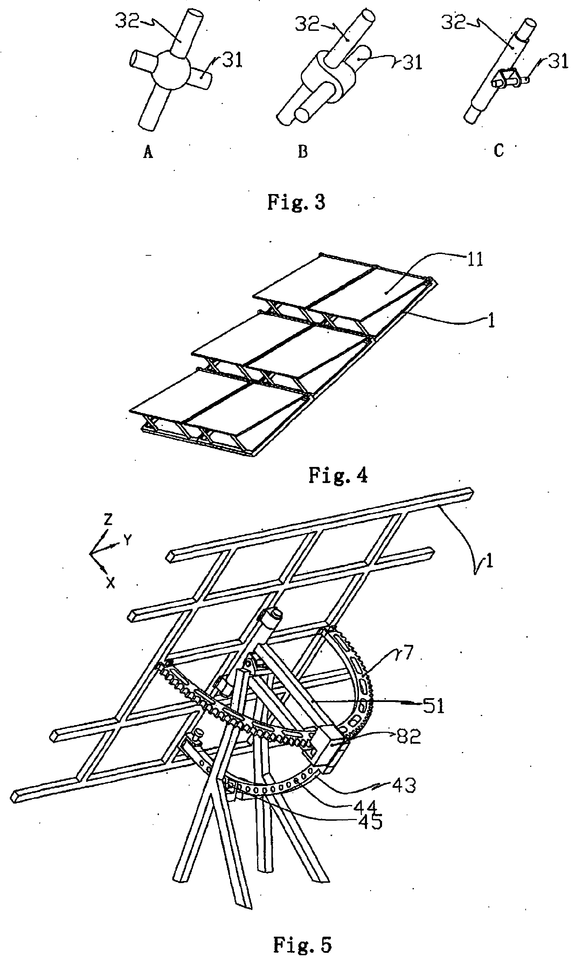

As shown in FIG. 4, the solar panel holder 1 can be a welded frame structure (or an aluminum section composite frame structure) for fixing a solar panel 11. Depending upon different latitude of regions where the solar panel is used, the solar panel 11 may be mounted parallel or at an inclination angle to the solar panel holder 1.

The mounting 2 is a lambdoid steel structure formed by welding, and a lower end of the mounting 2 is fastened to a foundation by fastening bolts, and an upper end of the mounting 2 is coupled to the solar panel holder 1 through a three-dimensional joint 3.

As shown in FIG. 3, the three-dimensional joint 3 includes a pitching angle rotation supporting shaft 31 and a left-right swing angle rotation supporting shaft 32 arranged in a cross shape. The two shafts can be arranged in various forms. Depending upon whether the two shafts are located in the same plane, the arrangement of the two shafts may be divided into two basic forms: a non-intersecting cross shaft in which the two shafts are not located in the same plane, and an intersecting cross shaft in which the two shafts are located in the same plane.

The intersecting cross shaft has two specific forms of which one is that the two shafts are integrated by welding as shown in FIG. 3(A), and the other is that the pitching angle rotation supporting shaft 31 passes through the left-right swing angle rotation supporting shaft 32, and the pitching angle rotation supporting shaft 31 is rotatable with respect to the left-right swing angle rotation supporting shaft 32 so as to form a joint.

The non-intersecting cross shaft has two forms of which one is that the two shafts welded to a connection piece and the two shafts are not located in the same plane as shown in FIG. 3(B), and the other is that one shaft is welded to the connection piece and the other shaft passes through a through hole disposed in the connection piece to form a configuration as shown in FIG. 3(C).

All of the above cross shafts can achieve the function that the solar panel holder 1 rotates about the swing angle rotation supporting shaft 32 and the pitching angle rotation supporting shaft 31, respectively. The three-dimensional joint 3 can be disposed at a center of gravity of the solar panel holder 1 to reasonably distribute gravity of the solar panel 11 and the solar panel holder 1, and is a main force-applied point.

The pitching angle tracking member comprises a first transmission part. Preferably, the first transmission part is a rigid circular arc body provided with a transmission structure, which is indicated by the rigid arc body 43. One end of the rigid arc body 43 is hinged to a back of the solar panel holder 1. Most preferably, the hinged point should be located on a downwardly-extended elongation line of the swing angle rotation supporting shaft of the three-dimensional joint 3. The other end of the rigid arc body 43 is fixed to a free end of a rigid support 51 by welding or by means of a bolt. Therefore the rigid arc body, the rigid support and the swing angle rotation supporting shaft are integrally connected and located in the same plane. The rigid support 51 is an H-shaped bracket, and is welded to the swing angle rotation supporting shaft of the three-dimensional joint 3 so that the rigid support is only capable of rotating synchronously with a pitching angle of the solar panel holder 1 and is not capable of rotating with respect to the solar panel holder 1. A first drive device 81 is fixedly mounted on the mounting 2. Preferably, the first drive device is a synchronous motor provided with a worm speed reducer. A gear is mounted on an output shaft of the worm speed reducer and indicated by the first gear 61. The first gear 61 meshes with teeth disposed on the rigid arc body 43. The first gear 61 controls operation of the rigid arc body 43. The rigid arc body 43 drives the solar panel holder 1 to rotate with the pitching angle rotation supporting shaft 31 of the three-dimensional joint serving as a center so as to adjust a pitching angle.

In order to ensure that tracking is accurate and setting of control program is simple and reasonable, in an example, the teeth on the rigid arc body 43 is disposed in a reasonable proportion to 180 degrees. A sector plane formed by the rigid arc body 43 is perpendicular to the ground level in a direction of a longitude of the earth, and is perpendicular to a sector plane in which a rigid semi-circular arc body 7 is located.

The swing angle tracking member comprises the rigid semi-circular arc body 7 provided with a transmission structure. The transmission structure comprises teeth proportionally disposed on the rigid semi-circular arc body according to data of variation in an angle of the sun during one day to form a shape of a large gear ring. Both ends of the rigid semi-circular arc body 7 are fixed to the solar panel holder 1 by bolts or are welded to the solar panel holder 1. Most preferably, two fixation points of the two ends are located on an imaginary elongation line of the pitching angle rotation supporting shaft of the three-dimensional joint to control the solar panel holder to rotate around the swing angle rotation supporting shaft of the three-dimensional joint. Preferably, the second drive device 82 is a synchronous motor provided with a worm speed reducer. The second drive device 82 is fixedly mounted at the free end of the rigid support 51. A gear is mounted on an output shaft of the worm speed reducer and indicated by the second gear 62. The second gear meshes with the rigid semi-circular arc body 7 to control operation of the rigid semi-circular arc body 7 for purpose of controlling the solar panel holder 1 to adjust a swing angle.

Take the Northern Hemisphere as an example, the sun initially rises or sets at a northern angle in most regions on the earth after the vernal equinox and before the autumnal equinox in every year. In an example, the mountings 2 are installed in a lambdoid shape to be inclined at an inclination angle depending upon different latitudes of regions where the device is used, or the solar panels 11 on the solar panel holder 1 are divided into groups to be installed at an inclination angle, so that an initial actuation position of the solar panel holder 1 can be expanded to an angle of east by north.

In order to ensure that the tracking is accurate and control program is simplified, the sector plane in which the rigid semi-circular arc body 7 is located is perpendicular to the plane in which the solar panel holder 1 is positioned.

A program control box for controlling operation of the first drive device 81 and the second drive device 82 may be mounted on the mounting 2, or a central control system may be employed. A motor operation control program is set based on astronomical constants. The two drive devices cooperate with each other by setting reasonable program to simulate a movement locus of the sun during one day, so that the device has a function of accurately tracking sun with the two shafts.

Specifically, before sunrise in the morning, the automatic sunlight tracking device is positioned in an initial state where the device is faced directly to the sunrise orientation. From the initial state after the sunrise in the morning, the program controls operation of the second drive device, so that the second transmission part drives the solar panel holder to swing along the left-right direction, and the solar panel holder is stopped until a set time before sunset. At the same time, the program controls operation of the first drive device, so that the first transmission part drives the solar panel holder to operate according to an angle set by the program. Until the solar panel holder reaches a point corresponding to the highest altitude angle of the sun at noon on a day, the first drive device rotates to a set angle in a reverse direction under the control of the program. Hence, complicated astronomical calculation is simplified in such a way that the two particularly crossed transmission parts, i.e., the rigid arc body 43 and the rigid semi-circular arc body 72, cooperate by means of a number of teeth corresponding to a prescribed swing angle rotated in a prescribed period of time and a number of teeth corresponding to a prescribed pitching angle rotated in each prescribed period of time in order to achieve corresponding coordinate points. Correction is achieved in a direction of the pitching angle to ensure that the solar panel 11 is always maintained to be perpendicular to the sunlight.

The two drive devices cooperate with each other, and operation of the two drive devices is stopped until a prescribed time before sunset in the afternoon. Finally, the program controls the automatic sunlight tracking device to return to the initial state for the next morning.

When a wind force reaches a set level, the program controls the solar panel holder to be positioned in a horizontal state as a wind avoiding state. When it snows, the program controls the solar panel holder to be positioned in a vertical state as a snow avoiding state.

The above operation of the automatic sunlight tracking device has the advantages that the tracking is accurate, and refraction loss of the sunlight is minimized, which is especially suitable for a concentrated solar power generation device which requires high tracking accuracy, and achieves accurate tracking of the sunlight. In addition, the polar panels are divided into groups to be installed at an inclination angle so as to effectively reduce wind resistance. The above operation of the automatic sunlight tracking device has only the drawbacks that all of the two drive devices must operate in an appropriate time and power consumption of the automatic sunlight tracking device is relatively large.

Embodiment 2 (object of this invention)

As shown in FIG. 5, the embodiment of this invention is different from the first embodiment in that the rigid arc body 43 has a hole-shaped positioning structure. The positioning structure is an array of positioning holes 44 uniformly distributed on the rigid arc body so that angle adjustment and fixation can be achieved. The mounting 2 is provided with a fixation hole corresponding to the positioning holes 44 at a position adjacent to the rigid arc body 43. A positioning pin 45 (such as a cylindrical pin) can be inserted between the positioning hole 44 and the fixation hole to lock the rigid arc body 43 and the mounting 2 together. Therefore, a simple manual first drive device is formed so as to manually adjust the pitching angle.

The swing angle tracking member of the embodiment is substantially the same as that of the first embodiment.

The embodiment can automatically track the sunlight with a single shaft, but the pitching angle needs to be manually adjusted at intervals. The second transmission part rotates by a number of teeth corresponding to a prescribed degree in a prescribed period of time. Hence, the solar panel holder 1 is driven to track variation in a position of the sun on each day. Operation of the solar panel holder is stopped until a prescribed time before sunset in the afternoon. Finally, the solar panel holder returns to the initial state for the next morning. The pitching angle is manually adjusted according to variation in an altitude angle, occurring during a year, of the sun every preset days. The synchronous motor in the first embodiment may be omitted, and the positioning pin 45 is used for locking. Because of gravity balancing design of the device itself and lever action of the rigid support 51, the operation of the device is simple and easy. The pitching angle can be adjusted by locking by means of the manual positioning device mounted on the mounting 2. The automatic sunlight tracking device thus achieves a function of automatically tracking the sun with a single shaft.

The automatic sunlight tracking device has the advantages that cost is reduced, power consumption for tracking is decreased, the drive program needs to control only regular swing, the automatic sunlight tracking device is further simplified, and the cost is greatly reduced. However, the automatic sunlight tracking device has the only drawbacks that the pitching angle needs to be manually adjusted, and the automatic sunlight tracking device has a tracking error (less than 5% on average during one year) so that it cannot maximize utilization of the solar energy.

### Embodiment 3

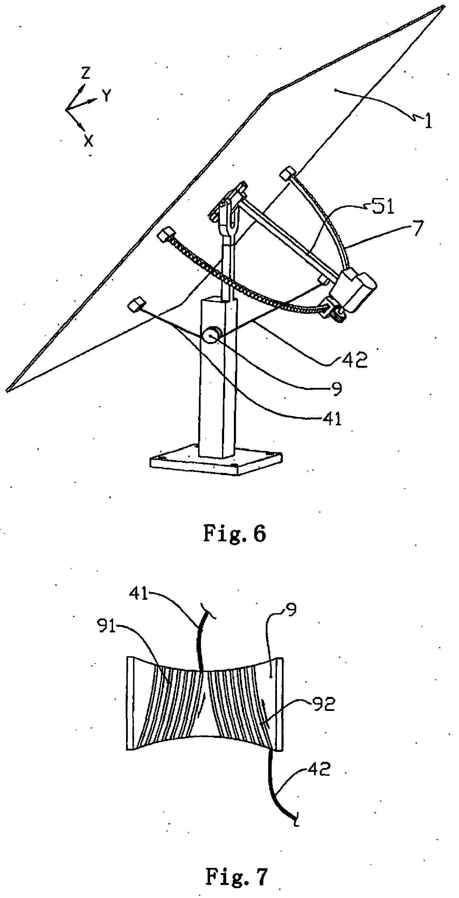

As showed in FIGS. 6 and 7, the third embodiment is different from the first embodiment in that the first transmission part is a transmission rope of a rope-like body and includes a third transmission rope 41 and a fourth transmission rope 42.

The first drive device comprises an electric motor and a worm speed reducer. A pulley 9 cooperating with the transmission ropes is mounted on an output shaft of the worm speed reducer. The pulley 9 has a cylindrical shape with a small diameter at a middle portion and a large diameter at both ends. The diameters are gradually changed from the middle portion to both sides. Third and fourth helical guide grooves 91 and 92 symmetrical about an intermediate cross section of the pulley are disposed on a cylindrical surface of the pulley. Helical directions of the two helical guide grooves are opposite to each other. Depths of the two helical guide grooves are designed according to requirements for winding of the transmission ropes. The third transmission rope 41 and the fourth transmission rope 42 are disposed in the third and fourth helical guide grooves, respectively. The third transmission rope 41 is fixed at an end to a right side of the third helical guide groove 91, and connected at the other end to the solar panel holder 1. The fourth transmission rope 42 is fixed at an end to a right side of the fourth helical guide groove 92, and connected at the other end to the rigid support 51. When the pulley rotates, the third transmission rope is wound and the fourth transmission rope is unwound so that the two transmission ropes are configured in a wound and unwound relationship, and vice versa. It can be ensured that the pitching angle can be smoothly adjusted by setting reasonable parameters of the helical guide grooves.

### Embodiment 4

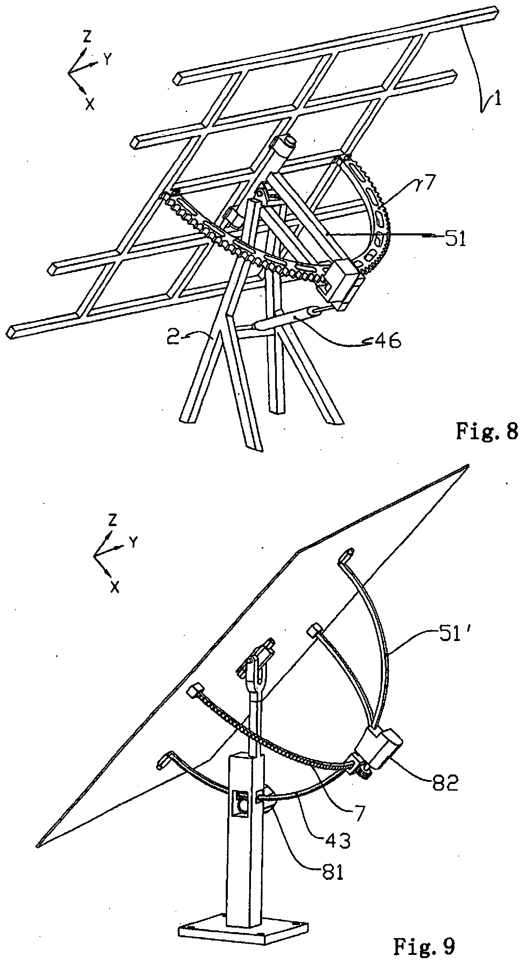

As shown in FIG. 8, the fourth embodiment is different from the first embodiment in that the pitching angle tracking member is a linearly-pushing rod 46 having two ends respectively hingedly connected to the rigid support 51 and the mounting 2. The linearly-pushing rod 46 extends and retracts by driving a screw by means of an electric motor so as to control the solar panel holder 1 to rotate by a corresponding angle around the pitching angle rotation supporting shaft 31.

Similarly, a hydraulic linearly-pushing rod and pneumatic linearly-pushing rod can substitute for the electrical linearly-pushing rod equivalently.

During actual use, the accurate tracking manner, in the first embodiment, in which the regular movements of the pitching angle tracking member and the swing angle tracking member cooperate with each other can be employed, but the tracking angle of the device is limited due to limitation of the linearly-pushing rod 46 itself; and a method in which the angle is adjusted by the linearly-pushing rod 46 according to law of variation of an altitude angle, occurring during a year, of the sun every preset days can be utilized.

The pitching angle may be adjusted by hingedly connecting the two ends of the linearly-pushing rod 46 to the solar panel holder 1 and the mounting 2.

### Embodiment 5

As shown in FIG. 9, the three-dimensional joint 3, the solar panel holder 1, the mounting 2, and the swing angle tracking member in the fifth embodiment are substantially the same as those in the first embodiment, but the fifth embodiment is different from the first embodiment in that both the first transmission part and the second transmission part are rigid arc bodies with tooth-shaped structures indicated by the rigid arc body 43 and the rigid semi-circular arc body 7. The rigid arc body 43 is a quadrant, while the rigid semi-circular arc body 7 is a semi-circular arc. A rigid support 51' is a quadrant having the same radius as the rigid arc body 43, and the rigid support 51' and the rigid arc body 43 are connected and combined to form a semi-circular arc.

The pitching angle tracking member comprises the solar panel holder 1, the rigid arc body 43, the rigid support 51', the mounting 2, the three-dimensional joint 3, and the first drive device 81.

The rigid arc body 43 and the arc-shaped rigid support 51' are integrally connected to constitute a semi-circular arc of 180 degrees as a whole. Both ends of the semi-circular arc are hingedly connected to the solar panel holder 1 along the Z axis. Most preferably, the two hingedly connection points are located on an elongation line of the swing angle rotation supporting shaft of the three-dimensional joint 3. An outer or inner periphery of the rigid arc body 43 is proportionally provided with teeth according to data of annual variation of an altitude angle of the sun.

The first drive device 81 mounted on the mounting 2 can effectively drive the rigid arc 43 to move by a gear on an output shaft of the first drive device 81. The rigid arc body 43 is controlled by the control program to rotate by a number of teeth corresponding to the annual variation of an altitude angle of the sun. The solar panel holder 1 is thus driven to rotate by a corresponding angle, thereby tracking variation in the angle of the sun in one year.

The gear transmission of the transmission structure on the rigid semi-circular arc body in the fifth embodiment may be replaced with a chain transmission structure and a frictional wheel transmission structure. The same transmission effect can be achieved with the chain transmission structure and the frictional wheel transmission structure.

### Embodiment 6

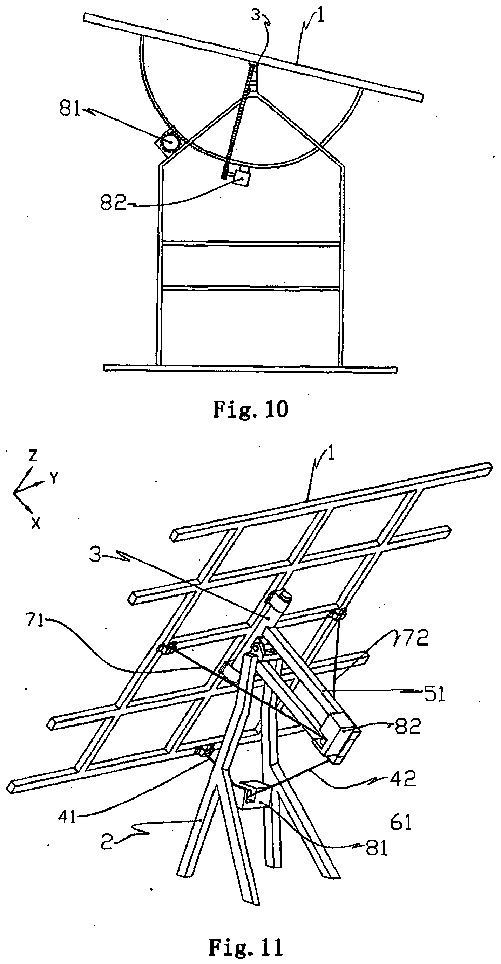

As shown in FIG. 10, the sixth embodiment is different from the fifth embodiment in that the second drive device 82 is disposed within the mounting 2 so that an operation range of the second drive device 82 is located within an angular space of an upper end of the mounting 2.

The mounting 2 is an A-shaped framework structure as a whole, and the A-shaped framework structure has the angular space at an upper portion. The mounting 2 is fixedly mounted on a base.

When an operation environment of the automatic sunlight tracking device operates is located in a lower-latitude region (between the Tropic of Capricorn and the Tropic of Cancer), a point at which the sun shines directly will exceed the zenith. Accordingly, the pitching angle of the solar panel holder 1 will exceed 180 degrees. In order to prevent the mounting 2 from inhibiting movement of the second drive device 82 mounted on the rigid support 51 so as to affect a range of operation of the solar panel holder 1, the upper portion of the mounting 2 needs to be designed as a structure with an open angular space and the effective angle of the open angular space should be larger than 46°52'. As result, the solar panel holder 1 can accurately track south and north variation of 23.5 degrees of the altitude angle of the sun occurring during one year in the proximity of the equator.

### Embodiment 7

As shown in FIG. 11, the three-dimensional joint, the solar panel holder, the mounting, and the rigid support in the seventh embodiment are substantially the same as those in the first embodiment, and the pitching angle tracking member in the seventh embodiment is substantially the same as that in the third embodiment.

The seventh embodiment differs from the previous embodiments in that the second transmission part comprises a rope-like body including a first transmission rope 71 and a second transmission rope 72. The second drive device 82 comprises an electric motor and a worm speed reducer, and a pulley which is capable of cooperating with the transmission ropes is mounted on an output shaft of the worm speed reducer. The pulley has the same structure as that in the third embodiment, and also has a cylindrical shape with a small diameter at a middle portion and a large diameter at both ends. First and second helical guide grooves symmetrical about an intermediate cross section of the pulley are disposed on a cylindrical surface of the pulley. The first and second transmission ropes 71 and 72 are disposed in the first and second helical guide grooves, respectively. Each of the first and second transmission ropes has an end fixed to an inside of the corresponding helical guide groove, and another end connected to the solar panel holder 1. The first and second transmission ropes are configured in a wound and unwound relationship. A surplus amount generated by relationship between a straight line and an arc can be effectively absorbed. As a result, the solar panel holder 1 is controlled to adjust the swing angle.

The above embodiments can be used by mutual combinations of the embodiments in different environments and conditions.

In an application in a large-scale photovoltaic power station system, the control box can be replaced with centralized control performed by a master control center to achieve various controls such as a light-sensing tracking function, a wind resisting function, and a snow prevention function. The device itself is designed to have excellent sand prevention and rust prevention functions.

## Claims

1. A sunlight tracking device comprising a solar panel holder (1), a mounting (2), a pitching angle tracking member, and a swing angle tracking member, wherein:
the solar panel holder (1) is coupled with the mounting (2) through a three-dimensional joint (3), the three-dimensional joint (3) includes a pitching angle rotation supporting shaft (31) and a swing angle rotation supporting shaft (32) arranged in a cross shape, the three-dimensional joint (3) is hingedly coupled to the mounting (2) through the pitching angle rotation supporting shaft (31), and the three-dimensional joint (3) is hingedly coupled to the solar panel holder (1) through the swing angle rotation supporting shaft (32);
a rigid support (51) is fixedly connected to the swing angle rotation supporting shaft (32) of the three-dimensional joint (3), and the rigid support (51) is only capable of rotating synchronously with a pitching angle of the solar panel holder (1);
the swing angle tracking member at least comprises a transmission part which is capable of rotating the solar panel holder (1) around the swing angle rotation supporting shaft (32) of the three-dimensional joint (3), and a drive device (82) fixed to the rigid support (51) to drive the transmission part to act,
**characterized in that**
the pitching angle tracking member comprising:
a rigid arc body (43) which is capable of rotating the solar panel holder (1) by means of the pitching angle rotation supporting shaft (31) of the three-dimensional joint (3), wherein the rigid arc body (43) has an end fixedly connected to the rigid support (51) or the swing angle rotation supporting shaft (32), the rigid arc body (43) has a hole-shaped, positioning structure (44);
a fixing hole disposed in the mounting (2); and
a positioning pin (45) which is capable of being inserted in the fixing hole and the hole-shaped positioning structure of the rigid arc body (43), wherein the pitching angle of the solar panel holder (1) can be manually adjusted and the rigid arc body (43) is locked to the mounting (2) by inserting the positioning pin in the fixing hole of the mounting (2) and the hole-shaped positioning structure of the rigid arc body (43).

2. The sunlight tracking device of claim 1, wherein:
the transmission part is a rigid semi-circular arc body (7) provided with a transmission structure, both ends of the rigid semi-circular arc body (7) are fixedly connected to the solar panel holder (1), and the drive device (82) drives the rigid semi-circular arc body (7) to rotate.

3. The sunlight tracking device of claim 2, wherein:
the rigid semi-circular arc body (7) has a tooth-shaped transmission structure, the drive device (82) comprises an electric motor and a worm speed reducer, and a gear meshing with the tooth-shaped transmission structure is mounted on an output shaft of the worm speed reducer.

## Patentansprüche

1. Sonnenlicht-Nachführvorrichtung, die einen Solarmodulhalter (1), einen Ständer (2), ein Nachführelement für den Neigungswinkel und ein Nachführelement für den Schwenkwinkel umfasst, wobei:
der Solarmodulhalter (1) mit dem Ständer (2) durch ein dreidimensionales Gelenk (3) verbunden ist, wobei das dreidimensionale Gelenk (3) eine Dreh-Stützwelle (31) für den Neigungswinkel und eine Dreh-Stützwelle (32) für den Schwenkwinkel in einer kreuzförmigen Anordnung umfasst,
wobei das dreidimensionale Gelenk (3) durch die Dreh-Stützwelle (31) für den Neigungswinkel schwenkbar mit dem Ständer (2) verbunden ist, und wobei das dreidimensionale Gelenk (3) durch die Dreh-Stützwelle (32) für den Schwenkwinkel schwenkbar mit dem Solarmodulhalter (1) verbunden ist,
ein starrer Halter (51) fest mit der Dreh-Stützwelle (32) für den Schwenkwinkel des dreidimensionalen Gelenks (3) verbunden ist, und wobei der starre Halter (51) nur dazu eingerichtet ist, synchron mit einem Neigungswinkel des Solarmodulhalters (1) zu drehen,
das Nachführelement für den Schwenkwinkel zumindest ein Übertragungsteil umfasst, das dazu eingerichtet ist, den Solarmodulhalter (1) um die Dreh-Stützwelle (32) für den Schwenkwinkel des dreidimensionalen Gelenks (3) zu drehen, und wobei eine am starren Halter (51) befestigte Antriebsvorrichtung (82) das Übertragungsteil für eine Betätigung antreibt,
wobei das Nachführelement für den Neigungswinkel Folgendes umfasst:
ein starres bogenförmiges Teil (43), das dazu eingerichtet ist, den Solarmodulhalter (1) mittels der Dreh-Stützwelle (31) für den Neigungswinkel des dreidimensionalen Gelenks (3) zu drehen, wobei das starre bogenförmige Teil (43) ein Ende aufweist, das fest mit dem starren Halter (51) oder der Dreh-Stützwelle (32) für den Schwenkwinkel verbunden ist, wobei das starre bogenförmige Teil (43) eine lochförmige Positionierungsstruktur (44) aufweist,
ein im Ständer (2) angeordnetes Befestigungsloch, und einen Positionierstift (45), der dazu eingerichtet ist, in das Befestigungsloch und die lochförmige Positionierungsstruktur des starren bogenförmigen Teils (43) eingeführt zu werden, wobei der Neigungswinkel des Solarmodulhalters (1) manuell eingestellt werden kann und das starre bogenförmige Teil (43) am Ständer (2) durch Einführen des Positionierstifts in das Befestigungsloch des Ständers (2) und die lochförmige Positionierungsstruktur des starren bogenförmigen Teils (43) gesichert wird.

2. Sonnenlicht-Nachführvorrichtung nach Anspruch 1, wobei:
das Übertragungsteil ein mit einer Übertragungsstruktur versehenes, starres halbkreisbogenförmiges Teil (7) ist, wobei beide Enden des starren halbkreisbogenförmigen Teils (7) fest mit dem Solarmodulhalter (1) verbunden sind, und die Antriebsvorrichtung (82) das starre halbkreisbogenförmige Teil (7) in Drehung versetzt.

3. Sonnenlicht-Nachführvorrichtung nach Anspruch 2, wobei:
das starre halbkreisbogenförmige Teil (7) eine zahnförmige Übertragungsstruktur aufweist, wobei die Antriebsvorrichtung (82) einen Elektromotor und ein schneckenartiges Untersetzungsgetriebe umfasst, und wobei ein Getriebe, das in die zahnförmige Übertragungsstruktur eingreift, an einer Abtriebswelle des Untersetzungsgetriebes angebracht ist.

## Revendications

1. Dispositif de poursuite du soleil comprenant un support de panneau solaire (1), une monture (2), un élément de poursuite selon l'angle de pas et un élément de poursuite selon l'angle d'oscillation, dans lequel :
le support de panneau solaire (1) est accouplé à la monture (2) par l'intermédiaire d'une articulation tridimensionnelle (3), l'articulation tridimensionnelle (3) comporte un arbre de support à rotation selon l'angle de pas (31) et un arbre de support à rotation selon l'angle d'oscillation (32) disposés en croix, l'articulation tridimensionnelle (3) est accouplée de manière articulée à la monture (2) par l'intermédiaire de l'arbre de support à rotation selon l'angle de pas (31), et l'articulation tridimensionnelle (3) est accouplée de manière articulée au support de panneau solaire (1) par l'intermédiaire de l'arbre de support à rotation selon l'angle d'oscillation (32) ;
un support rigide (51) est raccordé à demeure à l'arbre de support à rotation selon l'angle d'oscillation (32) de l'articulation tridimensionnelle (3), et le support rigide (51) ne peut que tourner de manière synchrone avec un angle de pas du support de panneau solaire (1) ;
l'élément de poursuite selon l'angle d'oscillation comprend au moins une pièce de transmission qui est apte à faire tourner le support de panneau solaire (1) autour de l'arbre de support à rotation selon l'angle d'oscillation (32) de l'articulation tridimensionnelle (3), et un dispositif d'entraînement (82) fixé au support rigide (51) pour entraîner la pièce de transmission afin de la faire entrer en action,
l'élément de poursuite selon l'angle de pas comprenant :
un corps en arc rigide (43) qui est apte à faire tourner le support de panneau solaire (1) au moyen de l'arbre de support à rotation selon l'angle de pas (31) de l'articulation tridimensionnelle (3), dans lequel le corps en arc rigide (43) présente une extrémité raccordée à demeure au support rigide (51) ou à l'arbre de support à rotation selon l'angle d'oscillation (32), le corps en arc rigide (43) possède une structure de positionnement en forme de trou (44) ;
un trou de fixation ménagé dans la monture (2) ; et
une goupille de positionnement (45) qui peut être insérée dans le trou de fixation et dans la structure de positionnement en forme de trou du corps en arc rigide (43), dans lequel l'angle de pas du support de panneau solaire (1) peut être réglé manuellement et le corps en arc rigide (43) est bloqué sur la monture (2) par l'insertion de la goupille de positionnement dans le trou de fixation de la monture (2) et dans la structure de positionnement en forme de trou du corps en arc rigide (43).

2. Dispositif de poursuite du soleil selon la revendication 1, dans lequel :
la pièce de transmission est un corps en arc semi-circulaire rigide (7) pourvu d'une structure de transmission, les deux extrémités du corps en arc semi-circulaire rigide (7) sont raccordées à demeure au support de panneau solaire (1), et le dispositif d'entraînement (82) entraîne le corps en arc semi-circulaire rigide (7) en rotation.

3. Dispositif de poursuite du soleil selon la revendication 2, dans lequel :
le corps en arc semi-circulaire rigide (7) possède une structure de transmission en forme de dent, le dispositif d'entraînement (82) comprend un moteur électrique et un réducteur de vitesse à vis sans fin, et un engrenage engrenant avec la structure de transmission en forme de dent est monté sur un arbre de sortie du réducteur de vitesse à vis sans fin.
